(19) Europäisches Patentamt
European Patent Office
Office européen des brevets

(11) **EP 4 398 287 A1**

(12) **EUROPEAN PATENT APPLICATION**
published in accordance with Art. 153(4) EPC

(43) Date of publication:
**10.07.2024 Bulletin 2024/28**

(21) Application number: **22864300.3**

(22) Date of filing: **19.08.2022**

(51) International Patent Classification (IPC):
*H01L 21/304* (2006.01)     *B24B 37/00* (2012.01)
*C01B 33/14* (2006.01)     *C09G 1/02* (2006.01)
*C09K 3/14* (2006.01)

(52) Cooperative Patent Classification (CPC):
**B24B 37/00; C01B 33/14; C09G 1/02; C09K 3/14; H01L 21/304**

(86) International application number:
**PCT/JP2022/031391**

(87) International publication number:
**WO 2023/032716 (09.03.2023 Gazette 2023/10)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **01.09.2021 JP 2021142157**

(71) Applicant: **Fujimi Incorporated**
**Kiyosu-shi, Aichi 452-8502 (JP)**

(72) Inventors:
• **TANABE, Yoshiyuki**
  **Kiyosu-shi, Aichi 452-8502 (JP)**
• **ASADA, Maki**
  **Kiyosu-shi, Aichi 452-8502 (JP)**
• **TSUCHIYA, Kohsuke**
  **Kiyosu-shi, Aichi 452-8502 (JP)**

(74) Representative: **Grünecker Patent- und Rechtsanwälte**
**PartG mbB**
**Leopoldstraße 4**
**80802 München (DE)**

(54) **POLISHING COMPOSITION**

(57) A polishing composition having excellent bump cancellation ability at a periphery of an HLM and being able to improve a polishing removal rate is provided. This polishing composition contains an abrasive, a basic compound, and water. The polishing composition contains a globular abrasive as the abrasive and further contains an alkali metal salt.

EP 4 398 287 A1

**Description**

[Technical Field]

The present invention relates to a polishing composition.

The present application claims priority based on Japanese Patent Application No. 2021-142157 filed on September 1, 2021, the entire contents of which are incorporated herein by reference.

[Background Art]

Conventionally, precision polishing has been performed using polishing compositions on surfaces of materials such as metals, metalloids, non-metals, and their oxides. For example, the surface of a silicon wafer, which is used as a component of a semiconductor product or the like, is generally finished to a high-quality mirror surface through lapping and polishing steps. The polishing step includes, for example, a pre-polishing step (stock polishing step) and a final polishing step (finish polishing step). The pre-polishing step includes, for example, a rough polishing step (primary polishing step) and an intermediate polishing step (secondary polishing step). Examples of a technical literature relating to the polishing composition used in the polishing step described above include Patent Literature 1. According to Patent Literature 1, the polishing removal rate is increased by using a semiconductor wafer polishing composition containing non-globular colloidal silica particles with atypical shapes to which urea is fixed.

[Citation List]

[Patent Literature]

[Patent Literature 1] Japanese Patent Application Publication No. 2011-086713

[Summary of Invention]

[Technical Problem]

For example, silicon wafers may be marked with barcodes, numbers, symbols, etc., (hard laser mark; hereinafter also referred to as "HLM") by irradiating the front or back surface of the silicon wafer with laser light for identification purposes or the like. The marking with the HLM is generally conducted after the end of the lapping step of the silicon wafer and before the start of the polishing step thereof. Normally, the irradiation of a silicon wafer with laser light for making the HLM generates a stressed layer on a portion of the surface of the silicon wafer at a periphery of the HLM. Although the HLM part itself of the silicon wafer is not used in final products, if the stressed layer is not polished appropriately in the polishing step after the marking with the HLM, such a part may become a bump, causing unnecessary reduction in the yield. However, the above stressed layer is difficult to be polished because it is transformed to polysilicon or the like due to energy of the laser light. For this reason, in recent years, there has been a particular need for a polishing composition for silicon wafers to flatten a bump at the periphery of the HLM (hereinafter also simply referred to as a "bump").

In order to flatten the bump at the periphery of the HLM, a polishing composition having a composition containing an abrasive with high removal ability (for example, composition containing non-globular colloidal silica particles with atypical shapes as suggested in Patent Literature 1) may be designed. With such a polishing composition, improvement of a polishing removal rate can also be expected. As a result of the present inventors' examinations, however, it has been clarified that by using a globular abrasive, which seems disadvantageous in flattening because of normally having low removal ability, in combination with an alkali metal salt, the bump cancellation ability superior to that of a composition containing a non-globular abrasive can be achieved and the polishing removal rate higher than or equal to that of the polishing composition containing the non-globular abrasive can be achieved. The present invention has been made based on the aforementioned knowledge, and it is an object of the present invention to provide a polishing composition having a composition containing a globular abrasive and excellent bump cancellation ability at a periphery of an HLM, and being able to improve a polishing removal rate.

[Solution to Problem]

According to the present invention, a polishing composition is provided. The polishing composition contains an abrasive, a basic compound, and water. The polishing composition contains a globular abrasive as the abrasive, and further contains an alkali metal salt. According to this polishing composition, excellent bump cancellation ability at a periphery of an HLM can be achieved and a polishing removal rate can also be improved with the composition containing the globular abrasive, which normally tends to have low removal ability.

It is noted that cancellation of bumps at the periphery of the HLM as used herein refers to decreasing the height from a reference surface (reference plane) around the HLM on a substrate to be polished (typically, semiconductor substrate, for example silicon wafer) up to the highest point of the bump. The height from the reference surface around the HLM of the substrate up to the highest point of the bump can be measured, for example, by a method described in an example to be mentioned below.

In some embodiments, an average aspect ratio of the globular abrasive based on SEM image analysis is 1.2 or less. By using the globular abrasive with an average aspect ratio of 1.2 or less, the effect of the art disclosed herein is preferably achieved.

In some embodiments, the globular abrasive is a silica particle. By using the globular silica abrasive, the effect of the art disclosed herein (bump cancellation effect in particular) can be exhibited more effectively.

In some preferred embodiments, the polishing composition contains a sulfate as the alkali metal salt. By using the sulfate as the alkali metal salt, the bump cancellation effect can be exhibited more effectively.

In some preferred embodiments, the polishing composition contains a quaternary ammonium as the basic compound. By employing the composition containing the quaternary ammonium as the basic compound, both the desired polishing removal rate and the bump cancellation at the periphery of the HLM can be achieved easily.

The polishing composition disclosed herein can be used to polish various kinds of materials. For example, the polishing composition disclosed herein can be suitably used in a polishing step for an object to be polished containing a silicon material. By using the polishing composition as described above to polish the object to be polished containing the silicon material and having a surface with the HLM, for example, the bump at the periphery of the HLM can be canceled while the polishing removal rate is improved. In addition, by the polishing composition described above, the high polishing removal rate can be achieved in polishing the object to be polished containing the silicon material. Accordingly, the polishing composition disclosed herein is particularly preferable as the polishing composition used in a stock polishing step that requires a higher polishing removal rate (for example, stock polishing step for a silicon substrate).

[Description of Embodiments]

Preferred embodiments of the present invention will be described below. Matters that are other than matters particularly mentioned in the present specification and that are necessary for the implementation of the present invention can be grasped as design matters of those skilled in the art based on the prior art in the relevant field. The present invention can be implemented based on contents disclosed in the present specification and common technical knowledge in the relevant field.

<Abrasive>

A polishing composition disclosed herein contains a globular abrasive as an abrasive. According to the art disclosed herein, excellent bump cancellation ability at a periphery of an HLM can be achieved and a polishing removal rate can also be improved by the composition containing the globular abrasive, which normally tends to have low removal ability. Here, the globular abrasive refers to a concept that is distinguished from a non-globular abrasive with atypical shapes, and encompasses particles (abrasive) that are substantially spherical and globular particles that can exhibit an operation effect similar to that of the spherical particles as the abrasive contained in the polishing composition. One kind of globular abrasive can be used alone or two or more kinds thereof can be used in combination. The following reasons are considered, for example, as to why the periphery of the HLM is flattened by the use of the globular abrasive, although the interpretation is not limited in particular. The abrasive in a state of secondary particles in the polishing composition can exhibit the removal ability for objects to be polished. For example, when the globular abrasive and the non-globular abrasive whose average primary particle diameters are about the same are compared, the former tends to have smaller average secondary particle diameter. Therefore, if both have the same content, the number of particles is larger in the globular abrasive and on the basis of this operation based on the number of particles, the globular abrasive is considered to effectively operate at the periphery of the HLM in a system in which a basic compound and an alkali metal salt are added. Note that this mechanism is considered by the present inventors on the basis of the experiment results and the interpretation of the art disclosed herein is not limited to this mechanism.

In some embodiments, the globular abrasive has an average aspect ratio of 1.2 or less (more specifically, 1.20 or less). The globular abrasive (particle group) with the smaller average aspect ratio tends to become a particle group that is closer to a sphere; therefore, the globular abrasive (particle group) with the smaller average aspect ratio tends to exhibit the operation based on the globular shape (flattening the periphery of the HLM). From such viewpoints, the average aspect ratio of the globular abrasive is preferably 1.15 or less, more preferably 1.1 or less (for example, less than 1.10), still more preferably 1.07 or less, and particularly preferably 1.05 or less. The lower limit of the average aspect ratio of the globular abrasive is 1.0 or more in principle, and may be 1.01 or more (for example, 1.03 or more). Although not limited in particular, typical examples of the globular abrasive include the abrasive with an average aspect ratio of 1.2 or less (for example, silica abrasive, more specifically colloidal silica).

The shape (outer shape) and average aspect ratio of the abrasive can be grasped by, for example, observation with an electron microscope. A specific procedure for grasping the average aspect ratio includes, for example, drawing a minimum rectangle circumscribing each particle image for a predetermined number (for example, 200 particles) of abrasive particles in which the shape of an independent particle can be recognized by using a scanning electron microscope (SEM). Then, for the rectangle drawn for each particle image, a value obtained by dividing the length of a long side (long diameter value) by the length of a short side (short diameter value) is calculated as the ratio of the long diameter to the short diameter (aspect ratio). By arithmetically averaging the aspect ratios of the above predetermined number of particles, the average aspect ratio can be determined.

The average primary particle diameter of the globular abrasive is not limited in particular, and is preferably 5 nm or more, more preferably 10 nm or more, and particularly preferably 20 nm or more from the viewpoints of achieving both the polishing removal rate and the bump cancellation ability, and the like. From the viewpoint of achieving the higher polishing effect, the average primary particle diameter is preferably 25 nm or more and more preferably 30 nm or more. The globular abrasive with an average primary particle diameter of 40 nm or more may be used. In some embodiments, the average primary particle diameter may be, for example, more than 40 nm, more than 45 nm, or more than 50 nm. From the viewpoints of preventing occurrence of scratches and the like, the globular abrasive has an average primary particle diameter of preferably 200 nm or less, more preferably 150 nm or less, still more preferably 120 nm or less, and particularly preferably 100 nm or less. In some embodiments, the average primary particle diameter may be 75 nm or less, or 60 nm or less.

In the present specification, the average primary particle diameter of the abrasive refers to the particle diameter that is calculated from the specific surface area (BET value) measured by a BET method on the basis of the following formula: average primary particle diameter (nm) = $6000/($true density $(g/cm^3) \times$ BET value $(m^2/g))$. For example, in the case of silica particles, the average primary particle diameter can be calculated from the following formula: average primary particle diameter (nm) = $2727/$BET value $(m^2/g)$. The specific surface area can be measured, for example, by using a surface area measuring device "FlowSorb II 2300" (trade name) manufactured by Micromeritics Instrument Corporation.

The average secondary particle diameter of the globular abrasive is not limited in particular and may be selected as appropriate from the range of about 15 nm to 300 nm, for example, From the viewpoints of improving the polishing removal rate and the bump cancellation ability, the average secondary particle diameter is preferably 30 nm or more and more preferably 35 nm or more. In some embodiments, the average secondary particle diameter may be, for example, 40 nm or more or 45 nm or more, and preferably 50 nm or more, and more preferably 60 nm or more or 65 nm or more (for example, 70 nm or more). From the viewpoint of preventing the occurrence of the scratches, the average secondary particle diameter is 250 nm or less, which is normally advantageous, and is preferably 200 nm or less, and more preferably 150 nm or less. In some preferred embodiments, the average secondary particle diameter may be 120 nm or less, 100 nm or less, 90 nm or less, or 85 nm or less. According to the art disclosed herein, the excellent bump cancellation ability can be achieved using the globular abrasive with the small average secondary particle diameter.

In the present specification, the average secondary particle diameter of the abrasive refers to a particle diameter measured by a dynamic light scattering method. For example, the model "FPAR-1000" manufactured by Otsuka Electronics Co., Ltd. or its equivalent product can be used in the measurement.

In some embodiments, a ratio $(P_2/P_1)$ of an average secondary particle diameter $P_2$ to an average primary particle diameter $P_1$ of the globular abrasive is 1.8 or less, for example. As described thus, the globular abrasive whose average secondary particle diameter is restricted with respect to the average primary particle diameter contains more secondary particles relatively than the abrasive with the larger average secondary particle diameter at a predetermined content, and tends to exhibit the removal ability (flattening operation) based on the number of secondary particles. From such viewpoints, the ratio $(P_2/P_1)$ is preferably 1.6 or less and more preferably 1.5 or less, and may be 1.45 or less. The lower limit of the ratio $(P_2/P_1)$ may be 1.10 or more, 1.20 or more, or 1.30 or more, for example. Although not limited in particular, the abrasive whose ratio $(P_2/P_1)$ is 1.8 or less (preferably 1.6 or less) (for example, silica abrasive, more specifically colloidal silica) is a typical example of the globular abrasive.

The material and properties of the abrasive (typically, globular abrasive) contained in the polishing composition are not particularly limited, and can be selected as appropriate depending on how the polishing composition is used, for example. As the abrasive, any of inorganic particles, organic particles, and organic-inorganic composite particles can be used. Specific examples of the inorganic particles include: oxide particles such as silica particles, alumina particles, cerium oxide particles, chromium oxide particles, titanium dioxide particles, zirconium oxide particles, magnesium oxide particles, manganese dioxide particles, zinc oxide particles, and red oxide particles; nitride particles such as silicon nitride particles and boron nitride particles; carbide particles such as silicon carbide particles and boron carbide particles; diamond particles; carbonates such as calcium carbonate and barium carbonate; and the like. Specific examples of the organic particles include polymethyl methacrylate (PMMA) particles, poly(meth)acrylate particles, polyacrylonitrile particles, and the like. Here, (meth)acrylate is a term encompassing acrylate and methacrylate. One kind of abrasive can be used alone or two or more kinds thereof can be used in combination.

As the globular abrasive, the inorganic particles are preferable and in particular, particles of oxides of metals or metalloids are preferable. A suitable example of the globular abrasive that can be used in the art disclosed herein is silica particles. The art disclosed herein can be preferably implemented in an embodiment in which the globular abrasive is substantially composed of silica particles, for example. The term "substantially" as used herein refers to 95 wt% or more of particles constituting the abrasive (preferably 98 wt% or more, and more preferably 99 wt% or more, and it may be 100 wt%), which are composed of silica particles.

The kind of silica particles is not particularly limited, and can be selected as appropriate. One kind of silica particles may be used alone or two or more kinds thereof may be used in combination. A preferable example of the silica particles is colloidal silica. By using globular colloidal silica, the periphery of the HLM can be suitably flattened. Using colloidal silica can easily exhibit favorable polishing performance (such as performance in reducing the surface roughness) while suppressing the occurrence of scratches on the surface of the object to be polished. The kind of colloidal silica is not particularly limited, and can be selected as appropriate. One kind of colloidal silica may be used alone or two or more kinds thereof may be used in combination. Colloidal silica prepared by an ion exchange method using water glass (Na silicate) as a raw material and alkoxide method colloidal silica can be preferably adopted as examples of the colloidal silica. Herein, the alkoxide method colloidal silica refers to colloidal silica produced by a hydrolytic condensation reaction of an alkoxysilane.

The polishing composition disclosed herein may contain the non-globular abrasive in the range not degrading the effect of the invention. Specific examples of the non-globular particles include a peanut shape (i.e., a peanut shell shape), a cocoon shape, a conpeito shape, a rugby-ball shape, etc.

The ratio of the globular abrasive (globular particles) in all the abrasive contained in the polishing composition is suitably about 90 wt% or more and may be 99 wt% or more, for example, The art disclosed herein is preferably implemented in an embodiment in which substantially all the abrasive contained in the polishing composition is the globular abrasive. That is to say, the polishing composition disclosed herein is preferably implemented in an embodiment in which the non-globular abrasive is not contained.

The content of the abrasive (typically, globular abrasive) is not particularly limited, and can be set as appropriate depending on its purpose. The content of the abrasive relative to the entire weight of the polishing composition may be, for example, 0.01 wt% or more, 0.05 wt% or more, or 0.1 wt% or more. As the content of the abrasive increases, the polishing removal rate tends to improve and the bump cancellation ability also generally tends to improve. In some embodiments, the content of the abrasive may be 0.2 wt% or more, 0.3 wt% or more, or 0.5 wt% or more. In some embodiments, from the viewpoints of preventing scratches and saving the amount of used abrasive, the content of the abrasive may be, for example, 10 wt% or less, 5 wt% or less, 3 wt% or less, 2 wt% or less, 1.5 wt% or less, 1.2 wt% or less, 1.0 wt% or less, or 0.8 wt% or less. These contents can be preferably applied to the content in a polishing slurry (working slurry) that is supplied to the object to be polished, for example.

In the case of a polishing composition that is diluted and used for polishing (i.e., a concentrate), the content of the abrasive is normally suitably 50 wt% or less, and more preferably 40 wt% or less from the viewpoints of storage stability, filterability, and the like. From the viewpoint of making use of the advantage of producing the polishing composition in the form of a concentrate, the content of the abrasive is preferably 1 wt% or more, and may be 5 wt% or more, for example.

<Alkali metal salt>

Another characteristic of the polishing composition disclosed herein is that an alkali metal salt is contained. By using the globular abrasive and the alkali metal salt in combination, the excellent bump cancellation ability at the periphery of the HLM can be achieved and the polishing removal rate that is higher than or equal to that of the polishing composition containing the non-globular abrasive can be achieved. Alkali metals that are contained in the alkali metal salt described above are lithium (Li), sodium (Na), potassium (K), rubidium (Rb), and cesium (Cs). The alkali metal salt contains one kind or two or more kinds of the aforementioned alkali metals. Above all, the alkali metal salt preferably contains at least one kind selected from Li, Na, and K, and more preferably contains K. The alkali metal salt is particularly preferably potassium salt. One kind of alkali metal salt may be used alone, or two or more kinds thereof may be used in combination.

The alkali metal salt may be either an inorganic acid salt or an organic acid salt. Examples of the inorganic acid salt include salts of hydrohalic acids (for example, hydrochloric acid, hydrobromic acid, hydriodic acid, and hydrofluoric acid), nitric acid, sulfuric acid, sulfurous acid, thiosulfuric acid, carbonic acid, silicic acid, boric acid, phosphoric acid, and the like. Examples of the organic acid salt include salts of carboxylic acids (for example, formic acid, acetic acid, propionic acid, benzoic acid, glycinic acid, lactic acid, citric acid, tartaric acid, and trifluoroacetic acid), organic sulfonic acids (for example, methanesulfonic acid, trifluoromethane sulfonic acid, benzenesulfonic acid, and toluenesulfonic acid), sulfamic acids, organic phosphonic acids (for example, methylphosphonic acid, benzenephosphonic acid, and toluenephosphonic acid), organic phosphoric acid (for example, ethyl phosphoric acid), and the like. Above all, the salts of hydrochloric acid, nitric acid, sulfuric acid, sulfurous acid, silicic acid, boric acid, and phosphoric acid are preferable, the salts of hydrochloric acid, nitric acid, and sulfuric acid are more preferable, and sulfate is particularly preferable.

Specific examples of the alkali metal salt include: chlorides such as lithium chloride, sodium chloride, and potassium chloride; bromides such as lithium bromide, sodium bromide, and potassium bromide; iodides such as lithium iodide, sodium iodide, and potassium iodide; fluorides such as lithium fluoride, sodium fluoride, and potassium fluoride; nitrates such as lithium nitrate, sodium nitrate, and potassium nitrate; sulfates such as lithium sulfate, sodium sulfate, and potassium sulfate; sulfites such as lithium sulfite, sodium sulfite, and potassium sulfite; hydrogensulfites such as lithium hydrogensulfite, sodium hydrogensulfite, and potassium hydrogensulfite; thiosulfates such as sodium thiosulfate and potassium thiosulfate; carbonates such as potassium carbonate, potassium hydrocarbonate, sodium carbonate, and sodium hydrocarbonate; silicates such as potassium silicate and sodium silicate; borates such as sodium borate; acetates such as potassium acetate and sodium acetate; and the like. One kind of alkali metal salt described above may be used alone, or two or more kinds thereof may be used in combination.

The content of the alkali metal salt in the polishing composition is not limited in particular and can be set suitably so that the effect of the art disclosed herein is exhibited. From the viewpoint of exhibiting the effect of adding the alkali metal salt effectively, generally, the content is suitably 0.001 wt% or more and from the viewpoints of improving the bump cancellation ability of the periphery of the HLM and improving the polishing removal rate, the content is preferably 0.005 wt% or more, more preferably 0.01 wt% or more, and still more preferably 0.02 wt% or more. The content of the alkali metal salt in the polishing composition is generally suitably 5 wt% or less, and from the viewpoints of dispersion stability and the like, the content may be 3 wt% or less, 1 wt% or less, 0.8 wt% or less, or 0.5 wt% or less.

A weight ratio ($C_{AMS}/C_{SA}$) of a content $C_{AMS}$ of the alkali metal salt to a content $C_{SA}$ of the globular abrasive in the polishing composition is not limited in particular as long as the effect of the art disclosed herein is exhibited. The ratio ($C_{AMS}/C_{SA}$) is suitably about 0.001 or more, for example, and from the viewpoint of exhibiting the effect of adding the alkali metal salt sufficiently, the ratio ($C_{AMS}/C_{SA}$) is preferably 0.01 or more, more preferably 0.02 or more, and still more preferably 0.05 or more (for example, more than 0.05). In addition, from the viewpoint of the removal ability for the periphery of the HLM based on the use of the globular abrasive, the ratio ($C_{AMS}/C_{SA}$) is suitably about 1 or less, for example, preferably 0.5 or less, and more preferably 0.3 or less.

<Basic compound>

The polishing composition disclosed herein contains a basic compound. The basic compound herein refers to a compound that has the function of increasing the pH of the polishing composition by being added to the composition. The basic compound acts to chemically polish the surface to be polished and can contribute to improving the polishing removal rate. The basic compound may be either an organic basic compound or an inorganic basic compound. One kind of basic compound can be used alone or two or more kinds thereof can be used in combination. Note that the basic compound disclosed herein does not contain the aforementioned alkali metal salt.

Examples of the organic basic compound include quaternary ammonium salts such as tetraalkyl ammonium salt. Examples of anions of the ammonium salt include $OH^-$, $F^-$, $Cl^-$, $Br^-$, $I^-$, $ClO_4^-$, $BH_4^-$, $HCO_3^-$, and the like. Preferable examples of the quaternary ammonium salts include choline, tetramethyl ammonium hydroxide, tetraethyl ammonium hydroxide, tetrapropyl ammonium hydroxide, tetrabutyl ammonium hydroxide, tetramethyl ammonium hydrocarbonate, and the like. Above all, tetramethyl ammonium hydroxide (TMAH) is preferable.

Other examples of the organic basic compound include quaternary phosphonium salts such as tetraalkyl phosphonium salt. Examples of anions of the phosphonium salt include $OH^-$, $F^-$, $Cl^-$, $Br^-$, $I^-$, $ClO_4^-$, $BH_4^-$, $HCO_3^-$, and the like. For example, halides, hydroxides, and the like of tetramethyl phosphonium, tetraethyl phosphonium, tetrapropyl phosphonium, tetrabutyl phosphonium, and the like can be preferably used.

Other examples of the organic basic compound include: amines such as methylamine, dimethylamine, trimethylamine, ethylamine, diethylamine, triethylamine, ethylenediamine, monoethanolamine, N-(β-aminoethyl)ethanolamine, hexamethylenediamine, diethylenetriamine, and triethylenetetramine; piperazines such as 1-(2-aminoethyl)piperazine and N-methylpiperazine; azoles such as imidazole and triazole; guanidine; and the like.

Examples of the inorganic basic compound include: ammonia; hydroxides of ammonia, alkali metal, and alkaline earth metal; carbonates of ammonia and alkaline earth metal; hydrogencarbonates of ammonia and alkaline earth metal; and the like.

From the viewpoints of improvement in the bump cancellation ability and the like, preferable examples of the basic compound include quaternary ammoniums (quaternary ammonium salts). One kind of quaternary ammoniums may be used alone or two or more kinds thereof may be used in combination. It is particularly preferable to use tetramethyl ammonium hydroxide.

From the viewpoints of the polishing removal rate and the bump cancellation ability, the content of the basic compound relative to the entire weight of the polishing composition is preferably 0.01 wt% or more, more preferably 0.05 wt% or more, and still more preferably 0.1 wt% or more. The stability can also be improved with increasing content of the basic compound. The upper limit of the content of the basic compound is suitably 5 wt% or less, and from the viewpoints of surface quality and the like, is preferably 2 wt% or less, more preferably 1 wt% or less, and still more preferably 0.5 wt% or less. When two or more kinds of basic compounds are used in combination, the above content refers to the total content of the two or more kinds of basic compounds. These contents can be preferably applied to the content in a polishing slurry (working slurry) that is supplied to an object to be polished, for example.

In the case of a polishing composition that is diluted and used for polishing (i.e., a concentrate), the content of the basic compound is normally suitably 10 wt% or less and more preferably 5 wt% or less from the viewpoints of storage stability, filterability, and the like. From the viewpoint of making use of the advantage of producing the polishing composition in the form of a concentrate, the content of the basic compound is preferably 0.1 wt% or more, more preferably 0.5 wt% or more, and still more preferably 0.9 wt% or more.

A weight ratio ($C_B/C_A$) of a content $C_B$ of the basic compound to a content $C_A$ of the abrasive in the polishing composition is not limited in particular as long as the effect of the art disclosed herein is exhibited. The ratio ($C_B/C_A$) is suitably about 0.01 or more, for example, and from the viewpoint of exhibiting the effect of adding the basic compound effectively, is preferably 0.05 or more, more preferably 0.1 or more, and for example 0.2 or more. From the viewpoints of mechanical polishing with the abrasive, dispersion stability of the composition, and the like, the ratio ($C_B/C_A$) is suitably about 1 or less, for example, preferably 0.8 or less, and more preferably 0.6 or less, and may be 0.5 or less, for example.

A weight ratio ($C_{AMS}/C_B$) of the content $C_{AMS}$ of the alkali metal salt to the content $C_B$ of the basic compound (for example, quaternary ammoniums) in the polishing composition is not limited in particular as long as the effect of the art disclosed herein is exhibited. The ratio ($C_{AMS}/C_B$) is suitably about 0.01 or more, for example, and from the viewpoints of improving the polishing removal rate and improving the bump cancellation ability, is preferably 0.05 or more, more preferably 0.1 or more, and still more preferably 0.2 or more. From the viewpoints of improving the polishing removal rate and the like, the ratio ($C_{AMS}/C_B$) is suitably about 10 or less, for example, and preferably 1 or less, and may be 0.8 or less.

<Water>

The polishing composition disclosed herein contains water. As the water, ion exchange water (deionized water), pure water, ultrapure water, distilled water, or the like can be preferably used. The water to be used preferably has a total content of transition metal ions of, for example, 100 ppb or less in order to avoid hindering the action of other components contained in the polishing composition as much as possible. For example, the purity of water can be enhanced by an operation such as removal of impurity ions by an ion exchange resin, removal of contaminants by the filter, or distillation.

The polishing composition disclosed herein may further contain an organic solvent (lower alcohol, lower ketone, or the like) that can be uniformly mixed with water, if necessary. Normally, it is preferable that 90 vol% or more of a solvent contained in the polishing composition be water, and it is more preferable that 95 vol% or more thereof (for example, 99 to 100 vol%) be water.

<Other components>

The polishing composition disclosed herein may further contain well-known additives that can be used in a polishing composition (for example, a polishing composition to be used in a polishing step of a silicon wafer), such as salts of anions containing sulfur (salt of S-containing anion), water-soluble polymers, surfactants, acids, chelating agents, antiseptic agents, and antifungal agents if necessary, as long as the effects of the present invention are not significantly impaired.

The salt of the S-containing anion may be either an organic salt or an inorganic salt. One kind of salt of S-containing anion can be used alone or two or more kinds thereof can be used in combination. Note that the salt of S-containing anion disclosed herein does not contain the alkali metal salt. Preferable examples of the salt of S-containing anion include inorganic salts. Examples of the inorganic salts include sulfates, sulfites, hydrogensulfites, thiosulfates, and the like. Cations contained in these salts are not limited in particular and examples thereof include alkaline earth metal, ammonium, and the like.

One kind of water-soluble polymers may be used alone or two or more kinds thereof may be used in combination. Examples of the water-soluble polymer include a cellulose derivative, a starch derivative, polymers containing an oxyalkylene unit, polymers containing a nitrogen atom, vinyl alcohol-based polymers, polymers containing a carboxylic acid (including an anhydride), and the like. Specific examples thereof include hydroxyethyl cellulose, pullulan, random copolymers or block copolymers of ethylene oxide and propylene oxide, polyvinyl alcohol, polyglycerin, polyacrylate, polyvinyl acetate, polyethylene glycol, polyvinylimidazole, polyvinylcarbazole, polyvinylpyrrolidone, polyacryloylmorpholine, polyvinylcaprolactam, polyvinylpiperidine, olefin-(maleic anhydride) copolymer, styrene-(maleic anhydride) copolymer, and the like. The art disclosed herein can be suitably implemented in an embodiment where the polishing composition substantially contains no water-soluble polymer, i.e., the composition does not contain the water-soluble polymer at least intentionally.

In the art disclosed herein, the molecular weight of the water-soluble polymer is not particularly limited. For example, the weight-average molecular weight (Mw) of the water-soluble polymer can be about $200 \times 10^4$ or less and is suitably $150 \times 10^4$ or less. The above Mw may be about $100 \times 10^4$ or less, or about $50 \times 10^4$ or less. From the viewpoint of protection of a surface of an object to be polished (for example, surface of silicon wafer), the above Mw is normally about $0.2 \times 10^4$ or more, and suitably about $0.5 \times 10^4$ or more, and may be about $0.8 \times 10^4$ or more.

As the Mw of the water-soluble polymer, a value on the basis of water-based gel permeation chromatography (GPC) (water-based, polyethylene oxide equivalent) can be adopted.

One kind of surfactant may be used alone or two or more kinds thereof may be used in combination. Examples of the surfactant are not particularly limited, but include anionic surfactants, nonionic surfactants, cationic surfactants, and amphoteric surfactants. By using the surfactant (for example, a water-soluble organic compound having a molecular weight of less than $0.2 \times 10^4$), the dispersion stability of the polishing composition can be improved. As the Mw of the surfactant, a value determined by GPC (water-based, polyethylene glycol equivalent) or a value calculated from a chemical formula can be adopted.

In some embodiments, the polishing composition has the composition in which the usage of the water-soluble polymer and the surfactant is limited. The total amount of the water-soluble polymer and the surfactant in the polishing composition (for example, polishing slurry) may be less than 0.3 wt%, less than 0.2 wt%, less than 0.1 wt%, less than 0.03 wt%, less than 0.01 wt%, or less than 0.0001 wt%. The art disclosed herein may be preferably implemented in an embodiment in which the polishing composition substantially contains no water-soluble polymer and/or surfactant, i.e., the polishing composition does not contain the water-soluble polymer and/or the surfactant at least intentionally.

One kind of acid may be used alone or two or more kinds thereof may be used in combination. Examples of the above acid include inorganic acids such as hydrochloric acid, phosphoric acid, sulfuric acid, phosphonic acid, nitric acid, phosphinic acid, and boric acid; organic acids such as acetic acid, itaconic acid, succinic acid, tartaric acid, citric acid, maleic acid, glycolic acid, malonic acid, methanesulfonic acid, formic acid, malic acid, gluconic acid, alanine, glycine, lactic acid, hydroxyethylidene diphosphate (HEDP), nitrilotris(methylenephosphonic acid) (NTMP), phosphonobutane tricarboxylic acid (PBTC); and the like.

One kind of chelating agent may be used alone or two or more thereof may be used in combination. Examples of the chelating agent include aminocarboxylic acid-based chelating agents, organophosphonic acid-based chelating agents, and organosulfonic acid-based chelating agents. Examples of the aminocarboxylic acid-based chelating agent include ethylenediaminetetraacetic acid, sodium ethylenediaminetetraacetic acid, nitrilotriacetic acid, sodium nitrilotriacetic acid, ammonium nitrilotriacetic acid, hydroxyethylethylenediaminetriacetic acid, sodium hydroxyethylethylenediaminetriacetic acid, diethylenetriaminepentaacetic acid, sodium diethylenetriamine pentaacetic acid, triethylenetetramine hexaacetic acid, and sodium triethylenetetramine hexaacetic acid. Examples of the organophosphoric acid-based chelating agent include 2-aminoethylphosphonic acid, 1-hydroxyethylidene-1,1-diphosphonic acid, aminotri(methylene phosphoric acid), ethylenediamine tetrakis(methylene phosphoric acid), diethylenetriamine penta(methylene phosphoric acid), ethane-1,1-diphosphonic acid, ethane-1,1,2-triphosphonic acid, ethane-1-hydroxy-1,1-diphosphoric acid, ethane-1-hydroxy-1,1,2-triphosphonic acid, ethane-1,2-dicarboxy-1,2-diphosphonic acid, methane hydroxyphosphonic acid, 2-phosphonobutane-1,2-dicarboxylic acid, 1-phosphonobutane-2,3,4-tricarboxylic acid, and $\alpha$-methylphosphonosuccinic acid. Examples of the organosulfonic acid-based chelating agent include ethylenediamine tetrakis methylene sulfonic acid. Among these, organophosphonic acid-based chelating agents are more preferable. Above all, preferred examples thereof include ethylenediamine tetrakis(methylene phosphoric acid), diethylenetriamine penta(methylene phosphoric acid), and diethylenetriaminepentaacetic acid. Particularly preferable examples of the chelating agent include ethylenediamine tetrakis(methylene phosphoric acid) and diethylenetriamine penta(methylenephosphonic acid).

Examples of the antiseptic agent and the antifungal agent include isothiazoline-based compounds, paraoxybenzoic acid esters, phenoxyethanol, and the like.

It is preferable that the polishing composition disclosed herein contain substantially no oxidant. If the polishing composition contains an oxidant, a surface of a substrate (for example, a silicon wafer surface) is oxidized by being supplied with the polishing composition to form an oxide layer, which can thereby reduce the polishing removal rate. Here, the polishing composition containing substantially no oxidant means that the oxidant is not blended at least intentionally, and a trace amount of oxidant that is inevitably contained due to raw materials, a manufacturing method, and the like is allowed to be present. The trace amount means that the molar concentration of the oxidant in the polishing composition is 0.0005 mol/L or less (preferably 0.0001 mol/L or less, more preferably 0.00001 mol/L or less, and particularly preferably 0.000001 mol/L or less). The polishing composition according to a preferred embodiment does not contain an oxidant. The polishing composition disclosed herein can be preferably implemented in an embodiment where, for example, any of hydrogen peroxide, sodium persulfate, ammonium persulfate, and sodium dichloroisocyanurate is not contained.

<Polishing composition>

The polishing composition disclosed herein is supplied to an object to be polished in the form of, for example, a polishing slurry (working slurry) containing the polishing composition, and is used to polish the object to be polished. For example, the polishing composition disclosed herein may be diluted (e.g., diluted with water) and used as a polishing slurry, or may be used in the form of the polishing slurry as it is. That is, the concept of the polishing composition in the art disclosed herein is inclusive of both a working slurry supplied to the object to be polished and used for polishing the object to be polished, and a concentrate (stock solution) of the working slurry. The concentration factor of the above concentrate may be, for example, about 2 to 140 times on a volume basis, and is normally suitably about 5 to 80 times.

The pH of the polishing composition is, for example, 8.0 or more, preferably 8.5 or more, more preferably 9.0 or more, and still more preferably 9.5 or more, and may be 10.0 or more (for example, 10.5 or more). As the pH becomes higher, the polishing removal rate tends to improve. In contrast, from the viewpoints of preventing dissolution of the abrasive (for example, silica particles) and suppressing reduction in the mechanical polishing effect with the abrasive, the pH of the polishing slurry is normally suitably 12.0 or less, preferably 11.8 or less, and more preferably 11.5 or less. These pH values can be preferably applied to the pH of both the polishing slurry (working slurry) supplied to the object to be polished and its concentrate.

The pH of the polishing composition can be grasped by performing three-point calibration using a standard buffer solution (a phthalate pH buffer solution, pH: 4.01 (at 25°C), a neutral phosphate pH buffer solution, pH: 6.86 (at 25°C), and a carbonate pH buffer solution, pH: 10.01 (at 25°C)) by using a pH meter (for example, a glass electrode type hydrogen ion concentration indicator manufactured by Horiba Ltd., (model number F-23)), then placing the glass electrode in the polishing composition, and measuring its pH value after two minutes or more have passed to stabilize the polishing composition.

The polishing composition disclosed herein may be of a single-agent type or a multi-agent type such as a double-agent type. For example, the polishing slurry may be configured to be prepared by mixing a part A containing at least the abrasive and a part B containing the remaining components, and diluting the mixture at appropriate timing if necessary.

A method for producing the polishing composition disclosed herein is not particularly limited. For example, the respective components constituting the polishing composition may be mixed using a known mixing device such as a blade type stirrer, an ultrasonic disperser, or a homomixer. How these components are mixed is not particularly limited. For example, all the components may be mixed at once, or may be mixed in a suitably set order.

<Polishing>

The polishing composition disclosed herein can be used for polishing an object to be polished, for example, in an embodiment including the following operations.

That is, a working slurry containing any one of the polishing compositions disclosed herein is prepared. Then, the polishing composition is supplied to the object to be polished, and the object is polished by a conventional method. For example, the object to be polished is set in a general polishing machine, and the polishing composition is supplied to the surface of the object to be polished (the surface to be polished) through a polishing pad of the polishing machine. For example, the polishing pad is pressed against the surface of the object to be polished while continuously supplying the above polishing composition thereto, and both the object and the polishing pad are relatively moved (for example, rotated). Through such a polishing step, the polishing of the object to be polished is completed.

The polishing pad used in the above polishing step is not particularly limited. For example, polishing pads of any type such as a polyurethane foam type, a non-woven fabric type, and a suede type, and a polishing pad containing an abrasive or containing no abrasive can be used. The above polishing machine may be a double-side polishing machine that polishes both sides of the object to be polished simultaneously, or a single-side polishing machine that polishes only one side of the object to be polished.

The above polishing composition may be used in such a way that once the polishing composition is used, it is disposed (so-called "in one-way"), or may be circulated and reused repeatedly. As an example of circulating and reusing the polishing composition, there is a proposed method that involves collecting, in a tank, a used polishing composition discharged from a polishing machine and supplying the collected polishing composition to the polishing machine again.

<Applications>

The polishing composition disclosed herein can be applied to polishing of objects to be polished that are made of various materials and have various shapes. The material of the object to be polished is, for example, a metal or metalloid such as silicon materials, aluminum, nickel, tungsten, copper, tantalum, titanium, and stainless steel and alloys thereof; a glassy substance such as quartz glass, aluminosilicate glass, and glassy carbon; a ceramic material such as alumina, silica, sapphire, silicon nitride, tantalum nitride, and titanium carbide; a compound semiconductor substrate material such as silicon carbide, gallium nitride, and gallium arsenide; a resin material such as polyimide resin; and the like. The object to be polished may be composed of a plurality of these materials.

The polishing composition disclosed herein is suitable for use in polishing an object to be polished containing a silicon material. As the silicon material, it is preferable to contain at least one kind of material selected from the group consisting of silicon single crystal, amorphous silicon, and polysilicon. The polishing composition is particularly preferable for use in polishing a substrate with silicon single crystal (for example, silicon wafer). The above polishing composition has excellent ability in cancellation of bumps at the periphery of the HLM (the bump cancellation ability) and can be preferably applied to polishing the surface to be polished, including the surface marked with the HLM. The polishing composition disclosed herein can be particularly preferably used in a stock polishing step, more specifically, a rough polishing step (primary polishing step), which is an initial polishing step in the polishing step, and a subsequent intermediate polishing step (secondary polishing step). Since the stock polishing step requires a higher polishing removal rate, it is particularly meaningful to use the polishing composition disclosed herein in the stock polishing step and achieve both the retention or improvement of the polishing removal rate and the bump cancellation of the periphery of the HLM.

The silicon wafer may be subjected to general treatment that can be applied to a silicon wafer, such as lapping, etching, and making of the HLM described above, before the polishing step using the polishing composition disclosed herein.

The above silicon wafer has a surface made of silicon, for example. Such a silicon wafer is preferably a silicon single crystal wafer, for example, a silicon single crystal wafer obtained by slicing a silicon single crystal ingot. The polishing composition disclosed herein is suitable for applications of polishing a silicon single crystal wafer having the HLM.

The polishing composition disclosed herein can also be suitably used for polishing an object to be polished that does not have the HLM.

Several examples relating to the present invention will be described below; however, the present invention is not intended to be limited to those described in the examples.

<Preparation of polishing composition>

(Example 1)

Colloidal silica as the abrasive, tetramethylammonium hydroxide (TMAH) as the basic compound, potassium sulfate as the alkali metal salt, and ion exchange water were mixed to prepare a concentrate of the polishing composition. The resulting concentrate of the polishing composition was diluted to 20 times on a volume basis with ion exchange water, thereby producing a polishing composition that contained 0.5 wt% of colloidal silica, 0.12 wt% of TMAH, and 0.07 wt% of potassium sulfate. The term wt% in Table 1 refers to % by weight and "-" refers to non-use. The colloidal silica is globular silica with an average primary particle diameter of 55 nm, an average secondary particle diameter of 78 nm, and an average aspect ratio of 1.04 based on SEM observation.

(Comparative Examples 1 and 2)

A polishing composition according to each example was prepared in a manner similar to Example 1 except that the compositions were changed as shown in Table 1. TMAC in Table 1 refers to tetramethyl ammonium hydrocarbonate.

(Comparative Example 3)

As the colloidal silica, non-globular silica with an average primary particle diameter of 55 nm, an average secondary particle diameter of 106 nm, and an average aspect ratio of 1.25 based on SEM observation was used. A polishing composition according to this example was prepared in a manner similar to Example 1 except the above.

<Performance evaluation>

(Polishing of silicon wafer)

A surface of an object to be polished (test piece) was polished under the following conditions using the polishing composition according to each example as it was, as the polishing slurry (working slurry). As the test piece, a commercially available silicon single crystal wafer (thickness: 545 $\mu$m, conductivity type: P type, crystal orientation: <100>, resistivity: 0.1 $\Omega \cdot$cm or more and less than 100 $\Omega \cdot$cm) having a diameter of 100 mm after lapping and etching was used. The wafer was marked with the HLM.

(Polishing conditions)

Polishing machine: Single-side polishing machine, model "EJ-380IN" manufactured by Engis Japan Corporation
Polishing pressure: 12 kPa
Platen rotational speed: +50 rpm (positive (+) if counterclockwise, this definition applies similarly to the description below.)
Head rotational speed: +50 rpm
Polishing pad: trade name "SUBA800" manufactured by NITTA DuPont Incorporated.
Flow rate of polishing slurry: 50 mL/minute (used in one-way)
Holding temperature of polishing environment: about 25°C
Polishing allowance: 4 μm

(Evaluation of HLM flatness)

In the silicon wafer after polishing, the surface shape at the periphery of the HLM was measured by using a stylus surface roughness tester (SURFCOM 1500DX, manufactured by TOKYO SEIMITSU CO., LTD.). Specifically, the stylus of the tester was brought into contact with the surface of the substrate, and the part at the periphery of the HLM was scanned by the stylus, whereby the height of a part with no bumps (reference surface) and the height of the bump were measured. The "HLM flatness" is defined as a height (μm) from the reference surface to the highest point of the bump. The obtained HLM flatness was converted into a relative value (relative HLM flatness [%]) in which the flatness according to Comparative Example 1 was 100%. The results obtained are shown in the "relative HLM flatness" column of Table 1. If the relative HLM flatness is less than 60%, the bump cancellation ability at the periphery of the HLM is evaluated to be excellent.

(Evaluation of polishing removal rate)

A polishing removal rate R [cm/min] in each of Examples and Comparative Examples was calculated by the following formulae (1) to (3), based on a difference in weight of the wafer before and after the polishing. The obtained polishing removal rate R was converted into a relative value (relative polishing removal rate [%]) on the assumption that the polishing removal rate of Comparative Example 1 was 100%. The obtained results are shown in the "relative polishing removal rate" column of Table 1. If the relative polishing removal rate is more than 105%, the polishing removal rate is evaluated as having been improved.

$$\Delta V = (W0 - W1)/d \quad (1)$$

$$\Delta x = \Delta V/S \quad (2)$$

$$R = \Delta x/t \quad (3)$$

ΔV: change in volume of wafer before and after polishing
W0: weight of wafer before polishing [g]
W1: weight of wafer after polishing [g]
d: specific gravity of silicon (2.33) [g/cm$^3$]
S: surface area of wafer [cm$^2$]
Δx: change in thickness of wafer before and after polishing [cm]
t: polishing time [min]

[Table 1]

Table 1

| | Abrasive | | | Basic compound | Alkali metal salt [wt%] | Organic salt | Relative HLM flatness [%] | Relative polishing removal rate [%] |
|---|---|---|---|---|---|---|---|---|
| | Shape | Content [wt%] | Average aspect ratio | TMAH [wt%] | | TMAC [wt%] | | |
| Example 1 | Globular | 0.5 | 1.04 | 0.12 | 0.07 | - | 55 | 108 |
| Comparative Example 1 | Globular | | 1.04 | | - | - | 100 | 100 |
| Comparative Example 2 | Globular | | 1.04 | | - | 0.08 | 43 | 102 |
| Comparative Example 3 | Non-globular | | 1.25 | | 0.07 | - | 77 | 107 |

As shown in Table 1, both the polishing removal rate and the HLM flatness were improved in Example 1 in which the polishing composition containing the globular abrasive, the basic compound, the alkali metal sa;t, and water was used, compared to Comparative Example 1 in which the polishing composition not containing the alkali metal salt was used. On the other hand, in Comparative Example 2 in which the alkali metal salt was not used and TMAC, which is the organic salt, was used, the bump at the periphery of the HLM where the relative HLM flatness was less than 60% was cancelled but the polishing removal rate was not improved sufficiently. It is considered difficult to achieve both the improvement of the polishing removal rate and the bump cancellation at the periphery of the HLM with the composition containing the globular abrasive just by the actions of the basic compound and the organic salt. Additionally, in Comparative Example 3 in which the non-globular abrasive was used instead of the globular abrasive, the polishing removal rate was improved but the bump cancellation ability at the periphery of the HLM was inferior to that in Example 1.

The above-described results indicate that using the polishing composition containing the abrasive, the basic compound, and water, in which the globular abrasive as the abrasive and the alkali metal salt were contained, makes it possible to achieve the excellent bump cancellation ability at the periphery of the HLM and improve the polishing removal rate.

Although specific examples of the present invention have been described in detail above, these are merely for illustrations and do not limit the scope of claims. The art according to the claims includes various modifications and changes made to the specific examples illustrated above.

**Claims**

1.   A polishing composition comprising an abrasive, a basic compound, and water, wherein

the polishing composition comprises a globular abrasive as the abrasive, and
further comprises an alkali metal salt.

2.   The polishing composition according to claim 1, wherein the globular abrasive has an average aspect ratio of 1.2 or less, the average aspect ratio being determined based on SEM image analysis.

3.   The polishing composition according to claim 1 or 2, wherein the globular abrasive is silica particles.

4.   The polishing composition according to any one of claims 1 to 3, further comprising a sulfate as the alkali metal salt.

5.   The polishing composition according to any one of claims 1 to 4, further comprising a quaternary ammonium as the basic compound.

6.   The polishing composition according to any one of claims 1 to 5, wherein the polishing composition is used in a polishing step for an object to be polished, the object containing a silicon material.

# EP 4 398 287 A1

## INTERNATIONAL SEARCH REPORT

| | International application No. |
|---|---|
| | **PCT/JP2022/031391** |

### A. CLASSIFICATION OF SUBJECT MATTER

*H01L 21/304*(2006.01)i; *B24B 37/00*(2012.01)i; *C01B 33/14*(2006.01)i; *C09G 1/02*(2006.01)i; *C09K 3/14*(2006.01)i
FI: H01L21/304 622D; C09K3/14 550D; C09K3/14 550Z; C09G1/02; B24B37/00 H; C01B33/14

According to International Patent Classification (IPC) or to both national classification and IPC

### B. FIELDS SEARCHED

Minimum documentation searched (classification system followed by classification symbols)

H01L21/304; B24B37/00; C01B33/14; C09G1/02; C09K3/14

Documentation searched other than minimum documentation to the extent that such documents are included in the fields searched

Published examined utility model applications of Japan 1922-1996
Published unexamined utility model applications of Japan 1971-2022
Registered utility model specifications of Japan 1996-2022
Published registered utility model applications of Japan 1994-2022

Electronic data base consulted during the international search (name of data base and, where practicable, search terms used)

### C. DOCUMENTS CONSIDERED TO BE RELEVANT

| Category* | Citation of document, with indication, where appropriate, of the relevant passages | Relevant to claim No. |
|---|---|---|
| X | JP 2020-25066 A (FUJIMI INC) 13 February 2020 (2020-02-13) paragraphs [0006]-[0074] | 1–6 |

☐ Further documents are listed in the continuation of Box C.   ☑ See patent family annex.

| | | |
|---|---|---|
| * | Special categories of cited documents: | "T" later document published after the international filing date or priority date and not in conflict with the application but cited to understand the principle or theory underlying the invention |
| "A" | document defining the general state of the art which is not considered to be of particular relevance | |
| "E" | earlier application or patent but published on or after the international filing date | "X" document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" | document referring to an oral disclosure, use, exhibition or other means | |
| "P" | document published prior to the international filing date but later than the priority date claimed | "&" document member of the same patent family |

| Date of the actual completion of the international search | Date of mailing of the international search report |
|---|---|
| **08 September 2022** | **01 November 2022** |

| Name and mailing address of the ISA/JP | Authorized officer |
|---|---|
| **Japan Patent Office (ISA/JP)** **3-4-3 Kasumigaseki, Chiyoda-ku, Tokyo 100-8915** **Japan** | |
| | Telephone No. |

Form PCT/ISA/210 (second sheet) (January 2015)

13

**INTERNATIONAL SEARCH REPORT**
Information on patent family members

| International application No. |
| --- |
| **PCT/JP2022/031391** |

| Patent document cited in search report | | | Publication date (day/month/year) | Patent family member(s) | Publication date (day/month/year) |
| --- | --- | --- | --- | --- | --- |
| JP | 2020-25066 | A | 13 February 2020 | KR 10-2019-0109236 A paragraphs [0006]-[0083] TW 201939596 A | |

Form PCT/ISA/210 (patent family annex) (January 2015)

**REFERENCES CITED IN THE DESCRIPTION**

**Patent documents cited in the description**

- JP 2021142157 A
- JP 2011086713 A